# EUROPÄISCHE PATENTANMELDUNG

(11) **EP 1 079 510 A2**
(43) Veröffentlichungstag der Anmeldung: **28.02.2001**
(21) Anmeldenummer: 00115943.3
(22) Anmeldetag: 25.07.2000
(51) Int. Cl.: H02M 7/538

(54) **Halbbrückenkonfiguration**

(30) Priorität: 27.07.1999 DE 19935100
(71) Anmelder: Infineon Technologies AG, 81541 München (DE)
(72) Erfinder: Sander, Rainald, 81543 München (DE); Gantioler, Josef-Matthias, 81925 München (DE); Xu, Chihao, Dr.,, 81249 München (DE); Auer, Frank, 85244 Röhrmoos (DE)
(74) Vertreter: Patentanwälte Westphal, Mussgnug & Partner

(57) **Zusammenfassung**

Um eine Last, z. B. einen Elektromotor bidirektional mit Strom zu versorgen, wird eine H-Brückenkonfiguration aus vier Schalttransistoren eingesetzt. Um sowohl eine hervorragende elektrische als auch thermische Leitfähigkeit zu erzielen, wird eine Halbbrückenkonfiguration aus zwei Transistoren (T1, T2) entgegengesetzten Leitfähigkeitstyps aufgebaut, wobei jeder Transistor (T1, T2) auf einem Chip (CH1, CH2) realisiert ist, die mit ihren Rückseiten auf einem gemeinsamen, vorzugsweise aus Metall hergestellten leitenden Träger (TO) sitzen. Jedes Gehäuse ist mit einem derartigen Träger ausgerüstet. Die Rückseite eines jeden der beiden Chips (CH1, CH2) wird aus der Drain- oder Sourceelektrode der Transistoren (T1, T2) gebildet. Die Last ist am Träger (TO) anschließbar. Es lassen sich zwei Halbbrückenkonfigurationen in vorteilhafter Weise zu einer H-Brückenkonfiguration kombinieren.

## Beschreibung

Die Erfindung betrifft eine Halbbrückenkonfiguration aus einem ersten und einem zweiten Transistor, wobei die beiden Transistoren mit ihren Streckenelektroden in Reihe geschaltet sind, wobei eine Betriebsspannung an der Reihenschaltung liegt und wobei an die miteinander verbundenen Streckenelektroden der beiden Transistoren eine Last anschließbar ist.

Um eine Last, z. B. einen Elektromotor, bidirektional mit Strom für Links- und Rechtslauf versorgen zu können, wird eine sogenannte H-Brückenkonfiguration eingesetzt. Eine H-Brücken-konfiguration ist eine Brückenschaltung aus vier Halbleiterschaltern, beispielsweise 4 MOSFETs, bei der die Last im Querzweig liegt, und in jedem Brückenzweig zwei Transistoren mit ihren Streckenelektroden in Reihe geschaltet sind. Mittels einer Ansteuerschaltung lassen sich die Transistoren so steuern, daß der Strom in der einen Richtung oder in der Gegenrichtung durch die Last, z. B. den erwähnten Elektromotor, fließt. Je nach Stromrichtung dreht sich der Elektromotor rechts- oder linksherum.

Aus der US-PS 5,703,390 ist eine Halbleiterschaltungsanordnung bekannt, bei der vier MOSFETs, die eine Brücke bilden, elektrisch isoliert auf einem Si-Träger sitzen. Wenn zum Schalten hoher Ströme große Leistungsschalter erforderlich sind, ist es jedoch kostengünstiger, die Leitungsschalter auf mehrere Träger zu verteilen, die funktionsspezifisch optimiert sind.

In der EP 0 809 292 A2 ist ein Leistungstransistormodul beschrieben, bei dem zwei Transistoren auf einem speziellen elektrisch isolierenden Substrat angeordnet sind, das auf einem Metallträger sitzt. Die beiden Transistoren sind in der erwähnten Halbbrückenkonfiguration angeordnet.

Die aus der US-PS 5,703,390 bekannte H-Brückenkonfiguration und die in der EP 0 809 292 A2 offenbarte Halbbrückenkonfiguration haben den Nachteil, daß die elektrische und die thermische Leitfähigkeit nicht optimal sind.

Es ist daher Aufgabe der Erfindung, eine Halbbrückenkonfiguration gemäß Oberbegriff des Anspruchs 1 so zu gestalten, daß die elektrische und die thermische Leitfähigkeit möglichst optimal sind.

Die Erfindung löst diese Aufgabe gemäß Anspruch 1 dadurch, daß die beiden Transistoren vom gegensätzlichen Leitfähigkeitstyp sind, daß jeder Transistor auf einem Chip realisiert ist, daß die beiden Chips mit ihrer Rückseite auf einem gemeinsamen elektrisch leitenden Träger sitzen, so daß eine Streckenelektrode des ersten Transistors mit der gleichen Streckenelektrode des zweiten Transistors verbunden ist, und der leitende Träger einen Summenpunkt bildet und daß die Last am leitenden Träger bzw. am Summenpunkt anschließbar ist.

Jeder Transistor ist auf einem Chip realisiert. Weil bei der erfindungsgemäßen Halbbrückenkonfiguration wegen der Verwendung von Transistoren gegensätzlichen Leitfähigkeitstyps im Gegensatz zu den bekannten Halbbrückenkonfigurationen gleiche Streckenelektroden - die Kollektoren oder die Emitter bzw. bei FETs die Drainelektroden oder die Sourceelektroden - anstelle ungleicher Streckenelektroden miteinander verbunden sind, können die Rückseiten der beiden Chips unmittelbar miteinander verbunden werden, denn sie realisieren die gleichen Streckenelektroden. Erfindungsgemäß wird diese Verbindung dadurch realisiert, daß die beiden Chips mit ihren Rückseiten auf einem gemeinsamen elektrisch leitenden Träger z. B. aus Metall sitzen. Durch die Maßnahme, die beiden Chips auf einem gemeinsamen elektrisch leitenden Träger zu setzen, werden sowohl eine optimale elektrische als auch thermische Verbindung und Leitfähigkeit zur Wärmeableitung erzielt.

Die Erfindung wird nun anhand der in der Zeichnung dargestellten Ausführungbeispiele beschrieben und erläutert.

In der Zeichnung zeigen:
- Fig. 1: den elektrischen Schaltkreis eines ersten Ausführungsbeispieles der Erfindung,
- Fig. 2: die Konfiguration des ersten Ausführungsbeispieles aus Fig. 1 auf einem Chipträger und
- Fig. 3: ein zweites Ausführungsbeispiel der Erfindung mit zwei Halbbrückenkonfigurationen.

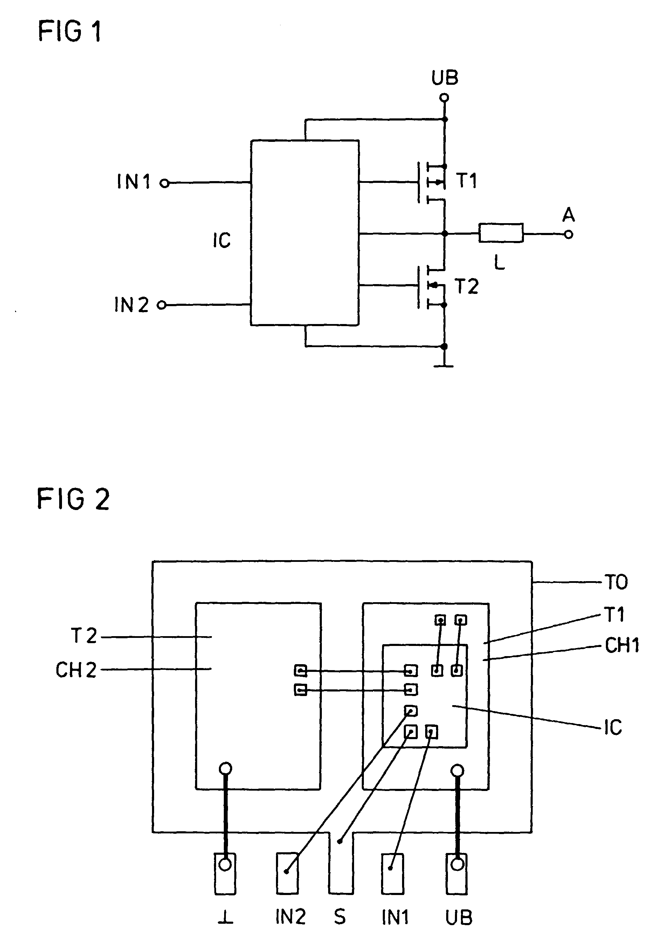

In der Fig. 1 sind zwei Transistoren T1 und T2 in Reihe geschaltet, die vom entgegengesetzten Leitfähigkeitstyp sind. Der Transistor T1, dessen Drainelektrode mit der Drain-elektrode des Transistors T2 verbunden ist, ist beispielsweise ein P-MOS-Feldeffekttransistor, während der Transistor T2 ein N-MOS-Feldeffekttransitor vom entgegengesetzten Leitfähigkeitstyp ist. An der Sourceelektrode des Transistors T1 liegt eine Betriebsspannung UB, währen die Sourceelektrode des Transistors T2 auf Masse liegt. An dem Verbindungspunkt der Drainelektroden der beiden Transistoren T1 und T2, der einen Summenpunkt S bildet, ist der erste Anschluß einer Last L angeschlossen, an deren zweiten Anschluß A die Betriebs-spannung UB liegt oder deren zweiter Anschluß A auf Masse liegt. Die Gateelektroden der beiden Transistoren T1 und T2 sind mit den Steuerausgängen einer Ansteuerschaltung IC verbunden, welche die beiden Transistoren T1 und T2 steuert. Die Betriebsspannung UB liegt an den Versorgungs-spannungseingängen der Ansteuerschaltung IC, die zwei Steuereingänge hat. Am einen Steuereingang liegt eine Steuerspannung IN1, am anderen eine Steuerspannung IN2.

Es wird nun die in Fig. 2 gezeigte Konfiguration des in Fig. 1 dargestellten Schaltkreises beschrieben und erläutert.

Die beiden Transistoren T1 und T2 sind als Chips CH1 und CH2 realisiert, die mit ihren Rückseiten, welche die Drainelektroden darstellen, auf einem gemeinsamen leitenden Träger TO, der z. B. aus Metall gefertigt sein kann, sitzen. Die Ansteuerschaltung IC ist ebenfalls als Chip realisiert, der elektrisch isoliert vorzugsweise auf dem höherohmigen der beiden Transistoren, dem P-MOS-Feldeffekttransitor T1 sitzt, denn ein p-leitender Transistor ist bei gleicher Chipfläche aus physikalischen Gründen stets höherohmig als ein n-leitender Transistor. Am Träger TO, der den Summenpunkt S bildet, ist eine Anschlußfahne für die Last L vorgesehen. Außerdem sind die externen Anschlüsse für die Versorgungs-spannung UB, für Masse sowie für die Steuerspannung IN1 und IN2 vorgesehen, die mittels Drahtverbindungen mit den entsprechenden Anschlüssen der Ansteuerschaltung IC und der beiden Transistoren T1 und T2 verbunden sind.

Besonders vorteilhaft ist es, das Chip der Ansteuerschaltung IC elektrisch isoliert auf den P-MOS-Feldeffekttransistor T1, dem höherohmigen der beiden Transistoren T1 und T2, anzuordnen, weil damit eine optimale thermische Kopplung zwischen dem Chip der Ansteuerschaltung IC und dem Chip CH1 des Transistors T1 erzielt wird.

In der Ansteuerschaltung IC wird bei einer Ausgestaltung der Erfindung die Temperatur im Chip ausgewertet. Weil das Chip der Ansteuerschaltung IC auf dem höherohmigen der beiden Transistoren T1 und T2 sitzt, spricht es frühzeitig auf Übertemperatur an und schützt durch Steuersignale die gesamte Konfiguration vor Zerstörung durch Überlast.

Die beste elektrische und thermische Verbindung und dadurch bedingt ein sicheres frühzeitiges Ansprechen auf Übertemperatur werden erzielt, wenn der Träger TO, auf dem die Chips CH1, CH2 und IC sitzen, wobei die Chips CH1 und IC übereinander liegen, an oder auf der Last L befestigt ist. Weil der Träger TO, das Chip CH1 und das Chip IC übereinander angeordnet sind, besteht eine ausgezeichnete Wärmeleitung von der Last L bis zum obersten Chip IC.

Die Steuerspannungen IN1 und IN2 sind einfache logische Signale, welche die Ansteuereinheit IC in Steuersignale für die beiden Transistoren T1 und T2 umsetzt. Sie verhindert das gleichzeitige Durchschalten der beiden Transistoren T1 und T2 und kann außerdem den Strom begrenzen.

Der P-MOS-Feldeffekttransistor T1 läßt sich im Gegensatz zu einem N-MOS-Feldeffekttransistor schnell und ohne Aufwand ansteuern, weil hierzu weder eine Ladungspumpe noch eine Boot-strap-Schaltung erforderlich ist.

Vorzugsweise sind die beiden Transistoren T1 und T2 in der kostengünstigen aber dennoch am besten elektrisch leitenden Vertikaltechnologie ausgeführt.

Die Erfindung benötigt nur wenige Pins, weil viele Verbindungen zwischen den drei Chips - der Ansteuerschaltung IC sowie der beiden Chips CH1 und CH2 der beiden Transistoren T1 und T2 - im Gehäuse verlaufen. Für diese internen Verbindungen entfällt der aufwendige ESD-Schutz.

Besonders vorteilhaft ist es, den metallischen Träger, den jedes Gehäuse besitzt, für den Träger TO und den Summenpunkt S vorzusehen. Hierfür eignen sich auch alle Standardgehäuse wie z. B. das Standardgehäuse TE220.

Ein weiterer Vorteil der Erfindung liegt darin, daß sich mehrere Halbbrücken zu beliebigen Konfigurationen kombinieren lassen, so daß sich eine große Vielfalt an Anwendungsmöglichkeiten ergibt.

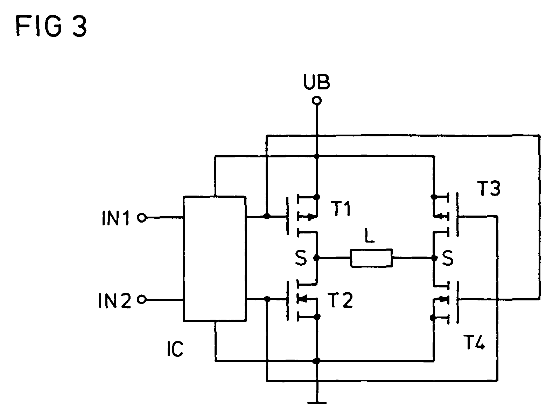

Eine Anwendungsmöglichkeit zeigt das in der Fig. 3 abgebildete zweite Ausführungsbeispiel der Erfindung.

In der Fig. 3 ist an die Halbbrückenkonfiguration aus der Fig. 1 eine zweite gleiche Halbbrückenkonfiguration aus zwei Transistoren T3 und T4 so angeschlossen, daß eine H-Brückenkonfiguration gebildet wird. Die Gateelektroden der sich jeweils diagonal gegenüberliegenden Transistoren T1 und T4 bzw. T2 und T3 sind mit dem einen bzw. mit dem anderen Steuerausgang der Ansteuerschaltung IC verbunden. Die Last L liegt zwischen den beiden Summenpunkten S. An den Sourceelektroden der beiden Transistoren T1 und T3 liegt die Versorgungsspannung UB, während die Sourceelektroden der beiden Transistoren T2 und T4 auf Masse liegen.

Die Erfindung ist sowohl für unidirektionalen als auch bidirektionalen Betrieb geeignet, wenn im letzten Fall zwei erfindungsgemäße Halbbrückenkonfigurationen zu einer Brücke ergänzt miteinander kombiniert werden. Weil jeweils zwei einen Transistor bildende Chips mit ihrer Rückseite auf einem gemeinsamen elektrisch leitenden Träger sitzen, liegen optimale elektrische und thermische Leitverhältnisse vor.

## Patentansprüche

1. Halbbrückenkonfiguration aus einem ersten und einem zweiten Transistor (T1, T2), wobei die beiden Transistoren (T1, T2) mit ihrem Streckenelektroden in Reihe geschaltet sind, wobei eine Betriebsspannung (UB) an der Reihenschaltung liegt und wobei an die miteinander verbundenen Streckenelektroden der beiden Transistoren (T1, T2) eine Last (L) anschließbar ist,
**dadurch gekennzeichnet**,
daß die beiden Transistoren (T1, T2) vom gegensätzlichen Leitfähigkeitstyp sind, daß jeder Transistor (T1, T2) auf einem Chip (CH1, CH2) realisiert ist, daß die beiden Chips (CH1, CH2) mit ihren Rückseiten auf einem gemeinsamen elektrisch leitenden Träger (TO) sitzen, so daß eine Streckenelektrode des ersten Transistors (T1) mit der gleichen Strekkenelektrode des zweiten Transistors (T2) verbunden ist, und der leitende Träger (TO) einen Summenpunkt bildet und daß die Last (L) am leitenden Träger (TO) bzw. am Summenpunkt (S) anschließbar ist.

2. Halbbrückenkonfiguration nach Anspruch 1,
**dadurch gekennzeichnet**,
daß der leitende Träger (TO) aus Metall gefertigt ist.

3. Halbbrückenkonfiguration nach Anspruch 1 oder 2,
**dadurch gekennzeichnet**,
daß der erste Transistor (T1) ein P-MOS-Feldeffekttransistor ist, daß der zweite Transistor (T2) ein N-MOS-Feldeffekttransitor ist, dessen Drainelektrode mit der Drainelektrode des ersten Transistors (T1) und mit dem Träger (TO) verbunden ist.

4. Halbbrückenkonfiguration nach Anspruch 1, 2 oder 3,
**dadurch gekennzeichnet**,
das die Gateelektroden der beiden Transistoren (T1, T2) mit einer Ansteuerschaltung (IC) verbunden sind, die Steuersignale für die Transistoren (T1, T2) erzeugt.

5. Halbbrückenkonfiguration nach Anspruch 4,
**dadurch gekennzeichnet**,
daß die Ansteuerschaltung (IC) auf einem Chip realisiert ist, das auf einem der beiden Transistoren (T1, T2) elektrisch isoliert angeordnet ist.

6. Halbbrückenkonfiguration nach Anspruch 5,
**dadurch gekennzeichnet**,
daß das Chip der Ansteuerschaltung (IC) auf dem höherohmigen der beiden Transistoren (T1, T2) sitzt.

7. Halbleiterkonfiguration nach Anspruch 6,
**dadurch gekennzeichnet**,
daß das Chip der Ansteuerschaltung IC auf den Transistor (T1) vom P-Leitfähigkeitstyp sitzt.

8. Halbbrückenkonfiguration nach einem der Ansprüche 1 bis 7,
**dadurch gekennzeichnet**,
daß der Träger (TO) zur Erzielung einer optimalen elektrischen und thermischen Verbindung auf der Last (L) sitzt.

9. Halbbrückenkonfiguration nach einem der Ansprüche 1 bis 8,
**dadurch gekennzeichnet**,
daß bei unidirektionalem Betrieb der zweite Anschluß (A) der Last (L) an einer Betriebsspannung (UB) oder auf Masse liegt,
daß bei bidirektionalem Betrieb der zweite Anschluß (A) der Last (L) am Summenpunkt (S) einer zweiten Halbbrückenkonfiguration angeschlossen ist.

10. Halbbrückenkonfiguration nach einem der vorangehenden Ansprüche,
**dadurch gekennzeichnet**,
daß die beiden Transistoren (T1, T2) in Vertikaltechnologie ausgeführt sind.

11. Halbbrückenkonfiguration nach einem der Ansprüche 4 bis 10,
**dadurch gekennzeichnet**,
daß im Chip der Ansteuerschaltung (IC) eine Temperaturüberwachungsschaltung integriert ist, welche die gesamte Halbbrükkenkonfiguration vor Zerstörung schützt.
